# EUROPEAN PATENT APPLICATION

(11) **EP 1 441 302 A2**
(43) Date of publication of application: **28.07.2004**
(21) Application number: 03257960.9
(22) Date of filing: 17.12.2003
(51) Int. Cl.: G06K 7/00, G06K 19/077

(54) **Conversion apparatus**

(30) Priority: 22.01.2003 JP 2003013580
(71) Applicant: FUJITSU LIMITED, Kawasaki-shi, Kanagawa 211-8588 (JP)
(72) Inventor: Nishioka, Tohru, c/o Fujitsu Limited, Kawasaki-shi Kanagawa 211-8588 (JP); Ogawa, Toru, c/o Fujitsu Limited, Kawasaki-shi Kanagawa 211-8588 (JP)
(74) Representative: Hitching, Peter Matthew

(57) **Abstract**

A conversion apparatus (1-1) is connectable to an information processing apparatus (2-1) which is designed for a device in conformance with a first specification. The conversion apparatus includes a connecting part (12) having a physical shape which enables a device in conformance with a second specification (3-1) to be connected to the information processing apparatus (2-1), a storage to store identification data of the device in conformance with the first specification, where the identification data is read from the storage in place of identification data stored within the connected device (3-1) in conformance with the second specification when the information processing apparatus (2-1) makes access to the identification data of the device, and a voltage converter to convert a power supply voltage from the information processing apparatus (2-1) into a converted power supply voltage in accordance with the second specification to be supplied to the device (3-1).

## Description

### BACKGROUND OF THE INVENTION

This application claims the benefit of a Japanese Patent Application No.2003-013580 filed January 22, 2003, in the Japanese Patent Office, the disclosure of which is hereby incorporated by reference.

### 1. Field of the Invention

The present invention generally relates to conversion apparatuses, and more particularly to a conversion apparatus which enables card-shaped devices having different specifications to be used in a host unit such as a personal computer.

Recently, card-shaped devices or portable card media, provided with an interface such as PCMCIA and CF (Compact Flash, registered trademark), are often used by being connected to a host unit such as a personal computer. There exist various specifications for the card-shaped devices. For example, the card-shaped device operates with a 5.0 V power supply voltage according to one specification, and the card-shaped device operates with a 3.3 V power supply voltage according to another specification. The card-shaped devices are often referred to as PC cards or CF cards, and are standardized by PC Card Standard Release 8.0 (Card Standard Volume 4 Metaformat Specification), CF+ & CF Specification Revision 1.4 (1998-99 Compact Flash Association) and the like.

### 2. Description of the Related Art

Conventionally, the host unit can only use a card-shaped device which conforms to a certain specification. For example, the host unit provisionally determines a power supply voltage to be supplied to the card-shaped device connected thereto, based on a physical shape of the card-shaped device, and thereafter reads card identification information (CIS information: Card Information Structure information) from the card-shaped device, so as to determine the power supply voltage corresponding to the host unit and the card-shaped device based on the CIS information. The CIS information is defined by Card Standard Volume 4 Metaformat Specification and the like.

For example, in the case of a host unit which can only use a card-shaped device in conformance with a specification which operates with a 5.0 V power supply voltage, the host unit provisionally determines the power supply voltage to be supplied to the card-shaped device connected thereto to 5.0 V, based on the physical shape of the card-shaped device, and thereafter reads the CIS information from the card-shaped device, so as to recognize that the card-shaped device conforms to the specification which operates with the 5.0 V power supply voltage, and determine the power supply voltage corresponding to the host unit and the card-shaped device to 5.0 V based on the CIS information.

However, in the case of the host unit which can only use the card-shaped device in conformance with the specification which operates with a 5.0 V power supply voltage, if the physical shape of the connected card-shaped device is recognized as that of a card-shaped device in conformance with the specification which operates with a 3.3 V power supply voltage, the host unit provisionally determines the power supply voltage to be supplied to the card-shaped device connected thereto to 3.3 V, based on the physical shape of the card-shaped device, and thereafter reads the CIS information from the card-shaped device, so as to recognize that the card-shaped device conforms to the specification which operates with the 3.3 V power supply voltage. However, since this host unit is designed for the card-shaped device in conformance with the specification which operates with the 5.0 V power supply voltage, this host unit cannot supply the 3.3 V power supply voltage to the card-shaped device connected thereto, and cannot use this card-shaped device in conformance with the specification which operates with the 3.3 V power supply voltage.

Similarly, in the case of a host unit which can only use the card-shaped device in conformance with the specification which operates with a 3.3 V power supply voltage, if the physical shape of the connected card-shaped device is recognized as that of a card-shaped device in conformance with the specification which operates with the 5.0 V power supply voltage, the host unit provisionally determines the power supply voltage to be supplied to the card-shaped device connected thereto to 5.0 V, based on the physical shape of the card-shaped device, and thereafter reads the CIS information from the card-shaped device, so as to recognize that the card-shaped device conforms to the specification which operates with the 5.0 V power supply voltage. However, since this host unit is designed for the card-shaped device in conformance with the specification which operates with the 3.3 V power supply voltage, this host unit cannot supply the 5.0 V power supply voltage to the card-shaped device connected thereto, and cannot use this card-shaped device in conformance with the specification which operates with the 5.0 V power supply voltage.

A Japanese Laid-Open Patent Application No.6-274710 proposes a method of changing an attribute of a card-shaped device from outside the card-shaped device.

On the other hand, a Japanese Laid-Open Patent Application No.8-56246 proposes a single host unit which can cope with card-shaped devices in conformance with various specifications.

According to the prior art, if attempts are made use card-shaped devices conforming to different specifications with respect to one host unit, it is conceivable to change the specification (attribute) of the card-shaped device from outside the card-shaped device to suit the design of the host unit, as proposed in the Japanese Laid-Open Patent Application No.6-274710. However, in order to change the attribute of the card-shaped device, there was a problem in that it is necessary to provide on the card-shaped device additional terminals exclusively for setting the attribute (that is, an exclusive external interface), and consequently modify the structure of the card-shaped device. In addition, there was another problem in that the card-shaped device having the exclusive external interface cannot maintain compatibility with the existing card-shaped device which do not have the exclusive external interface.

On the other hand, it is conceivable to design the host unit so as to be able to cope with the card-shaped devices in conformance with different specifications, as proposed in the Japanese Laid-Open Patent Application No.8-56246. But in this case, the host unit must be provided with circuits exclusively for each of the specifications of the card-shaped devices to be usable with the host unit. As a result, there was a problem in that the structure of the host unit becomes complex and the host unit becomes expensive.

### SUMMARY OF THE INVENTION

Accordingly, it is a general object of the present invention to provide a novel and useful conversion apparatus, in which the problems described above are eliminated.

Another and more specific object of the present invention is to provide a conversion apparatus which enables a card-shaped device in conformance with an arbitrary specification to be connected to and used with an information processing apparatus which is designed for a device in conformance with a certain specification, while maintaining compatibility with existing devices, and without requiring the structure of the information processing apparatus to be modified.

Still another object of the present invention is to provide a conversion apparatus connectable to an information processing apparatus which is designed for a device in conformance with a first specification, comprising a connecting part having a physical shape which enables a device in conformance with a second specification to be connected to the information processing apparatus, where the second specification is different from the first specification; a storage to store identification information of the device in conformance with the first specification, where the identification information is read from the storage in place of identification information stored within the device in conformance with the second specification and connected to the information processing apparatus, when the information processing apparatus makes access to the identification information of the device in conformance with the second specification; and a voltage converter to convert a power supply voltage from the information processing apparatus into a converted power supply voltage in accordance with the second specification and to supply the converted power supply voltage to the device in conformance with the second specification. According to the conversion apparatus of the present invention, it is possible to enable a device in conformance with an arbitrary specification to be connected to and used with an information processing apparatus which is designed for a device in conformance with a certain specification, while maintaining compatibility with existing devices, and without requiring the structure of the information processing apparatus to be modified.

Other objects and further features of the present invention will be apparent from the following detailed description when read in conjunction with the accompanying drawings.

### BRIEF DESCRIPTION OF THE DRAWINGS

FIG. 1 is a diagram for explaining a first embodiment of a conversion apparatus according to the present invention;
FIG. 2 is a diagram for explaining a second embodiment of the conversion apparatus according to the present invention;
FIG. 3 is a diagram for explaining a third embodiment of the conversion apparatus according to the present invention;
FIG. 4 is a diagram for explaining a fourth embodiment of the conversion apparatus according to the present invention;
FIG. 5 is a diagram showing an end surface shape of a connecting part of a PC card in conformance with a first specification;
FIG. 6 is a diagram showing an end surface shape of a connecting part of a PC card in conformance with a second specification;
FIG. 7 is a system block diagram showing a structure of the conversion apparatus;
FIG. 8 is a system block diagram showing a structure of a host unit;
FIG. 9 is a system block diagram showing a structure of a card-shaped device;
FIG. 10 is a diagram for explaining terminal numbers of a PC card, terminal numbers of an FC card, names of terminals shown in FIG. 7, and functions of the terminals;
FIG. 11 is a diagram for explaining the terminal numbers of the PC card, the terminal numbers of the FC card, the names of the terminals shown in FIG. 7, and the functions of the terminals; and
FIG. 12 is a flow chart for explaining an operation of the conversion apparatus.

### DESCRIPTION OF THE PREFERRED EMBODIMENTS

First, a description will be given of the operating principle of a conversion apparatus according to the present invention.

It is conceivable to use a conversion apparatus, such as an adapter, which converts a physical shape of a portable medium such as a card-shaped device, into a physical shape of a card-shaped device in conformance with another specification. For example, when connecting a card-shaped device in conformance with a specification which operates with a 3.3 V power supply voltage to an information processing apparatus which is designed for a card-shaped device in conformance with a specification which operates with a 5.0 V power supply voltage, it is conceivable to connect the card-shaped device in conformance with the specification which operates with the 3.3 V power supply voltage to this information processing apparatus via an adapter which converts the physical shape of the connecting card-shaped device into the physical shape of the card-shaped device in conformance with the specification which operates with the 5.0 V power supply voltage. In this case, due to the provision of the adapter, the information processing apparatus recognizes that the physical shape of the connected card-shaped device is the physical shape of the card-shaped device in conformance with the specification which operates with the 5.0 V power supply voltage. Hence, the information processing apparatus provisionally determines a power supply voltage to be supplied to the connected card-shaped device to 5.0 V, but thereafter reads card identification information such as CIS information from the connected card-shaped device and recognizes that the connected card-shaped device conforms to the specification which operates with the 3.3 V power supply voltage. In this case, since the information processing apparatus is designed for the card-shaped device in conformance with the specification which operates with the 5.0 V power supply voltage, the information processing apparatus cannot supply a 3.3 V power supply voltage to the connected card-shaped device, and thus, the connected card-shaped device cannot be used. Accordingly, even if a voltage conversion circuit is simply provided to convert the 5.0 V power supply voltage into the 3.3 V power supply voltage, it is impossible for the information processing apparatus which is designed for the card-shaped device in conformance with the specification which operates with the 5.0 V power supply voltage to use the card-shaped device in conformance with the specification which operates with the 3.3 V power supply voltage, because the card identification information read from the connected card-shaped device will indicate that the connected card-shaped device conforms to the specification which operates with the 3.3 V power supply voltage.

On the other hand, in the present invention, when connecting a device, such as a card-shaped device, in conformance with the specification which operates with the 3.3 V power supply voltage to an information processing apparatus which is designed for a device, such as a card-shaped device, in conformance with the specification which operates with the 5.0 V power supply voltage, for example, the device in conformance with the specification which operates with the 3.3 V power supply voltage is connected to the information processing apparatus via a conversion apparatus such as an adapter which converts the physical shape of the connecting device into the physical shape of the device in conformance with the specification which operates with the 5.0 V power supply voltage. In this case, due to the provision of the adapter, the information processing apparatus recognizes that the physical shape of the connected device is the physical shape of the device in conformance with the specification which operates with the 5.0 V power supply voltage, and the information processing apparatus provisionally determines a power supply voltage to be supplied to the connected device to 5.0 V. A storage which stores identification information of the device in conformance with the specification which operates with the 5.0 V power supply voltage is provided within the conversion apparatus. Hence, when the information processing apparatus makes access to the connected device to read the identification information therefrom, the conversion apparatus is accessed in place of the connected device, and the identification information of the device in conformance with the specification which operates with the 5.0 V power supply voltage is read from the conversion apparatus, even though the connected device conforms to the specification which operates with the 3.3 V power supply voltage. Consequently, the information processing apparatus recognizes the connected device as if it were a device in conformance with the specification which operates with the 5.0 V power supply voltage, even though the connected device is actually in conformance with the specification which operates with the 3.3 V power supply voltage. Accordingly, the information processing apparatus supplies a 5.0 V power supply voltage, which is converted into a 3.3 V power supply voltage by a voltage conversion circuit provided within the conversion apparatus, before being supplied to the connected device. Therefore, the information processing apparatus can use the connected device in conformance with the specification which operates with the 3.3 V power supply voltage, even though the information processing apparatus is designed for the device in conformance with the specification which operates with the 5.0 V power supply voltage. Similarly, by connecting a device in conformance with an arbitrary specification, via the conversion apparatus, to the information processing apparatus which is designed for a device in conformance with a predetermined specification, it becomes possible for the information processing apparatus to use the device in conformance with the arbitrary specification.

The CIS information (or data) standardized by PC Card Standard Release 8.0 (Card Standard Volume 4 Metaformat Specification), CF+ & CF Specification Revision 1.4 (1998-99 Compact Flash Association) and the like may be used as the (card) identification information.

Next, a description will be given of various embodiments of the conversion apparatus according to the present invention, by referring to the drawings.

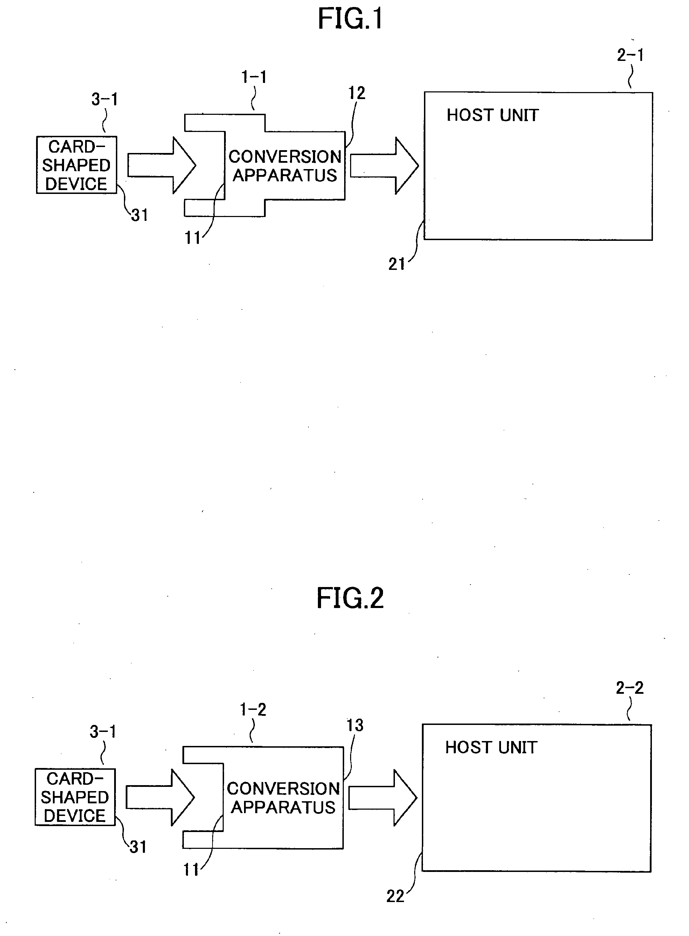

FIG. 1 is a diagram showing a first embodiment of the conversion apparatus according to the present invention. In FIG. 1, a conversion apparatus 1-1 is used by being connected to a host unit 2-1 and a card-shaped device 3-1. The host unit 2-1 is designed for a card-shaped device in conformance with a first specification (and/or standard). The host unit 2-1 may be formed by a known information processing apparatus such as a personal computer. The card-shaped device 3-1 conforms to a second specification (and/or standard) which is different from the first specification. Of course, it is not essential for the device 3-1 to be card shaped, and the device 3-1 may have other shapes.

The conversion apparatus 1-1 has a connecting part 11 which has a physical shape connectable to a connecting part 31 of the card-shaped device 3-1, and a connecting part 12 which has a physical shape connectable to a connecting part 21 of the host unit 2-1. The "physical shape" includes an arrangement of pins and/or contact terminals. Accordingly, the connecting part 11 of the conversion apparatus 1-1 has a structure including a plurality of pins similar to those of a connecting part of a host unit which is designed for a card-shaped device in conformance with the second specification, and has a physical shape for absorbing features of the physical shape of the card-shaped device in conformance with the second specification. The connecting part 12 of the conversion apparatus 1-1 has a structure including a plurality of pins similar to those of a connecting part of a card-shaped device in conformance with the first specification.

The card-shaped device 3-1 is connectable to the host unit 2-1 via the conversion apparatus 1-1. The conversion apparatus 1-1 includes a storage and a voltage converter. The storage stores card identification information of a card-shaped device in conformance with the first specification, and this card identification information is read from the storage in place of the card identification information stored within the card-shaped device 3-1 when the host unit 2-1 makes access to the card identification information of the connected card-shaped device 3-1. The voltage converter converts a power supply voltage in accordance with the first specification from the host unit 2-1 into a power supply voltage in accordance with the second specification, and supplies the converted power supply voltage to the card-shaped device 3-1.

For example, the card-shaped device 3-1 is a CF card in conformance with the second specification which uses a 5.0 V power supply voltage, and the host unit 2-1 is designed for a CF card in conformance with the first specification which uses a 3.3 V power supply voltage. The card-shaped device 3-1 has a known structure including a memory, a register and the like, and may also include a processor such as a CPU.

FIG. 2 is a diagram for explaining a second embodiment of the conversion apparatus according to the present invention. In FIG. 2, a conversion apparatus 1-2 is used by being connected to a host unit 2-2 and a card-shaped device 3-1. The host unit 2-2 is designed for a card-shaped device in conformance with a first specification (and/or standard). The host unit 2-2 may be formed by a known information processing apparatus such as a personal computer. The card-shaped device 3-1 conforms to a second specification (and/or standard) which is different from the first specification.

The conversion apparatus 1-2 has a connecting part 11 which has a physical shape connectable to a connecting part 31 of the card-shaped device 3-1, and a connecting part 13 which has a physical shape connectable to a connecting part 22 of the host unit 2-1. The "physical shape" includes an arrangement of pins and/or contact terminals. Accordingly, the connecting part 11 of the conversion apparatus 1-2 has a structure including a plurality of pins similar to those of a connecting part of a host unit which is designed for a card-shaped device in conformance with the second specification, and has a physical shape for absorbing features of the physical shape of the card-shaped device in conformance with the second specification. The connecting part 13 of the conversion apparatus 1-2 has a structure including a plurality of pins similar to those of a connecting part of a card-shaped device in conformance with the first specification.

The card-shaped device 3-1 is connectable to the host unit 2-2 via the conversion apparatus 1-2. The conversion apparatus 1-2 includes a storage and a voltage converter. The storage stores card identification information of a card-shaped device in conformance with the first specification, and this card identification information is read from the storage in place of the card identification information stored within the card-shaped device 3-1 when the host unit 2-2 makes access to the card identification information of the connected card-shaped device 3-1. The voltage converter converts a power supply voltage in accordance with the first specification from the host unit 2-2 into a power supply voltage in accordance with the second specification, and supplies the converted power supply voltage to the card-shaped device 3-1.

For example, the card-shaped device 3-1 is a CF card in conformance with the second specification which uses a 5.0 V power supply voltage, and the host unit 2-2 is designed for a PC card in conformance with the first specification which uses a 3.3 V power supply voltage. The card-shaped device 3-1 has a known structure including a memory, a register and the like, and may also include a processor such as a CPU.

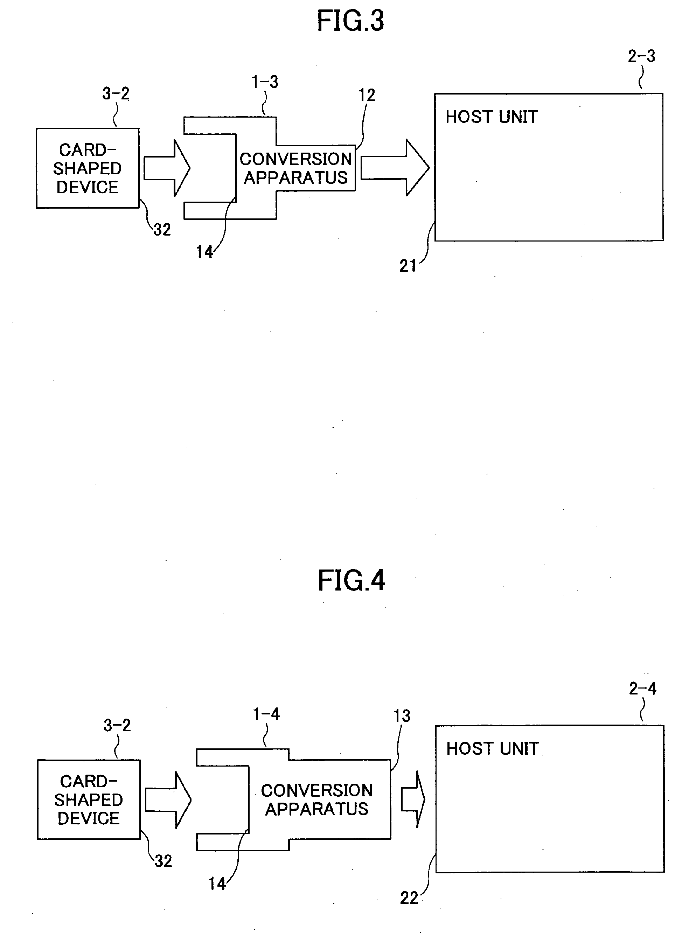

FIG. 3 is a diagram for explaining a third embodiment of the conversion apparatus according to the present invention. In FIG. 3, a conversion apparatus 1-3 is used by being connected to a host unit 2-3 and a card-shaped device 3-2. The host unit 2-3 is designed for a card-shaped device in conformance with a first specification (and/or standard). The host unit 2-3 may be formed by a known information processing apparatus such as a personal computer. The card-shaped device 3-2 conforms to a second specification (and/or standard) which is different from the first specification. Of course, it is not essential for the device 3-2 to be card shaped, and the device 3-2 may have other shapes.

The conversion apparatus 1-3 has a connecting part 14 which has a physical shape connectable to a connecting part 32 of the card-shaped device 3-2, and a connecting part 12 which has a physical shape connectable to a connecting part 21 of the host unit 2-3. The "physical shape" includes an arrangement of pins and/or contact terminals. Accordingly, the connecting part 14 of the conversion apparatus 1-3 has a structure including a plurality of pins similar to those of a connecting part of a host unit which is designed for a card-shaped device in conformance with the second specification, and has a physical shape for absorbing features of the physical shape of the card-shaped device in conformance with the second specification. The connecting part 12 of the conversion apparatus 1-3 has a structure including a plurality of pins similar to those of a connecting part of a card-shaped device in conformance with the first specification.

The card-shaped device 3-2 is connectable to the host unit 2-3 via the conversion apparatus 1-3. The conversion apparatus 1-3 includes a storage and a voltage converter. The storage stores card identification information of a card-shaped device in conformance with the first specification, and this card identification information is read from the storage in place of the card identification information stored within the card-shaped device 3-2 when the host unit 2-3 makes access to the card identification information of the connected card-shaped device 3-2. The voltage converter converts a power supply voltage in accordance with the first specification from the host unit 2-3 into a power supply voltage in accordance with the second specification, and supplies the converted power supply voltage to the card-shaped device 3-2.

For example, the card-shaped device 3-2 is a PC card in conformance with the second specification which uses a 5.0 V power supply voltage, and the host unit 2-3 is designed for a CF card in conformance with the first specification which uses a 3.3 V power supply voltage. The card-shaped device 3-2 has a known structure including a memory, a register and the like, and may also include a processor such as a CPU.

FIG. 4 is a diagram for explaining a fourth embodiment of the conversion apparatus according to the present invention. In FIG. 4, a conversion apparatus 1-4 is used by being connected to a host unit 2-4 and a card-shaped device 3-2. The host unit 2-4 is designed for a card-shaped device in conformance with a first specification (and/or standard). The host unit 2-4 may be formed by a known information processing apparatus such as a personal computer. The card-shaped device 3-2 conforms to a second specification (and/or standard) which is different from the first specification.

The conversion apparatus 1-4 has a connecting part 14 which has a physical shape connectable to a connecting part 32 of the card-shaped device 3-2, and a connecting part 13 which has a physical shape connectable to a connecting part 22 of the host unit 2-4. The "physical shape" includes an arrangement of pins and/or contact terminals. Accordingly, the connecting part 14 of the conversion apparatus 1-4 has a structure including a plurality of pins similar to those of a connecting part of a host unit which is designed for a card-shaped device in conformance with the second specification, and has a physical shape for absorbing features of the physical shape of the card-shaped device in conformance with the second specification. The connecting part 13 of the conversion apparatus 1-4 has a structure including a plurality of pins similar to those of a connecting part of a card-shaped device in conformance with the first specification.

The card-shaped device 3-2 is connectable to the host unit 2-4 via the conversion apparatus 1-4. The conversion apparatus 1-4 includes a storage and a voltage converter. The storage stores card identification information of a card-shaped device in conformance with the first specification, and this card identification information is read from the storage in place of the card identification information stored within the card-shaped device 3-2 when the host unit 2-4 makes access to the card identification information of the connected card-shaped device 3-2. The voltage converter converts a power supply voltage in accordance with the first specification from the host unit 2-4 into a power supply voltage in accordance with the second specification, and supplies the converted power supply voltage to the card-shaped device 3-2.

For example, the card-shaped device 3-2 is a PC card in conformance with the second specification which uses a 5.0 V power supply voltage, and the host unit 2-4 is designed for a PC card in conformance with the first specification which uses a 3.3 V power supply voltage. The card-shaped device 3-2 has a known structure including a memory, a register and the like, and may also include a processor such as a CPU.

As described above, the card-shaped device in conformance with the first specification and the card-shaped device in conformance with the second specification may be the same kind of card-shaped devices or, may be mutually different kinds of card-shaped devices. The same kind of card-shaped devices may be PC cards or, may be FC cards. On the other hand, the different kinds of card-shaped devices may be a PC card and an FC card.

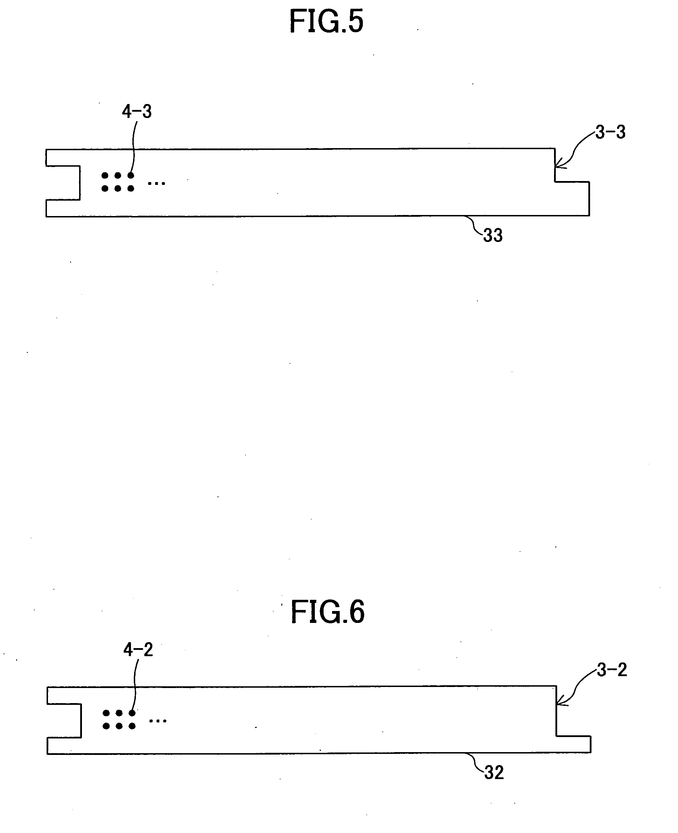

FIG. 5 is a diagram showing an end surface shape of a connecting part 33 having contact terminals 4-3 of a PC card 3-3 in conformance with the first specification which uses the 3.3 V power supply voltage. FIG. 6 is a diagram showing an end surface shape of a connecting part 32 having contact terminals 4-2 of a PC card 3-2 in conformance with the second specification which uses the 5.0 V power supply voltage. The end surface shapes of the connecting parts 33 and 32 shown in FIGS. 5 and 6 mutually differ, and the host units 2-1 through 2-4 can recognize the specification of each card-shaped device from the different physical shapes of the card-shaped devices using a known means. An end surface shape of a connecting part having contact terminals of an FC card in conformance with the first specification which uses the 3.3 V power supply voltage and an end surface shape of a connecting part of an FC card in conformance with the second specification which uses the 5.0 V power supply voltage mutually differ, and may have shapes similar to the end surface shapes shown in FIGS. 5 and 6, respectively.

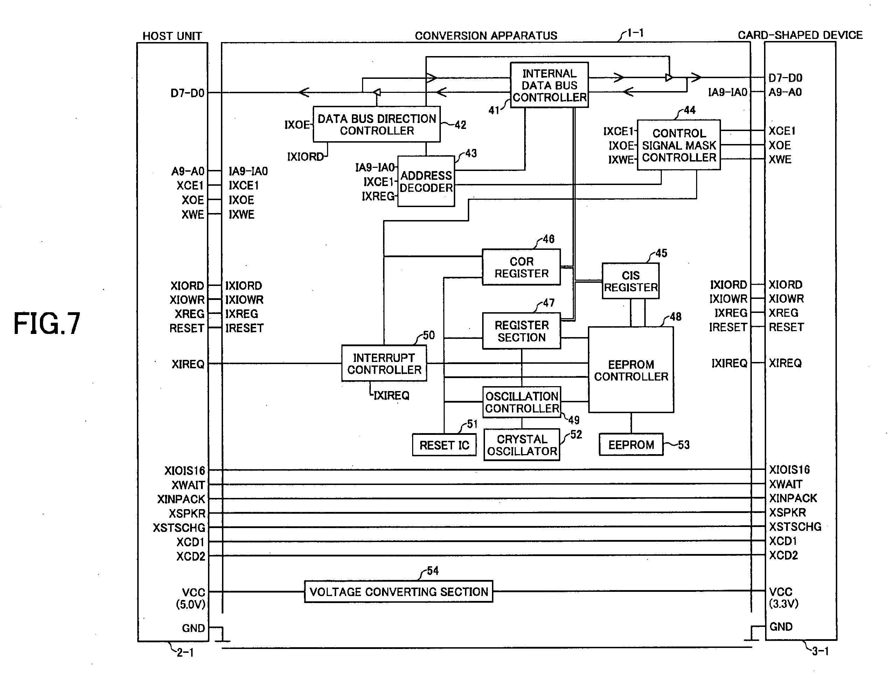

Next, a description will be given of the structure of the conversion apparatus, by referring to FIG. 7. FIG. 7 is a system block diagram showing the structure of the conversion apparatus. Because the structures of the conversion apparatuses 1-1 through 1-4 shown in FIGS. 1 through 4 are basically the same, only the structure of the conversion apparatus 1-1 will be described in the following. For the sake of convenience, FIG. 7 only shows those terminals which need to be connected to the conversion apparatus 1-1 and are directly related to the operation of this embodiment.

In FIG. 7, the conversion apparatus 1-1 includes an internal data bus controller 41, a data bus direction controller 42, an address decoder 43, a control signal mask controller 44, a CIS register 45, a COR register 46, a register section 47, an EEPROM controller 48, an oscillation controller 49, an interrupt controller 50, a reset IC 51, a crystal oscillator 52, an EEPROM 53 and a voltage converter 54.

The internal data bus controller 41 controls input and output of a data bus within the conversion apparatus 1-1. The data bus direction controller 42 controls directions of input and output of the data bus with respect to the host unit 2-1 and the card-shaped device 3-1. The address decoder 43 decodes address bits A0 through A9 which will be described later. The control signal mask controller 44 controls masking of a card enable signal (card selection signal) CE1, an output enable signal OE and a write enable signal WE which will be described later.

The CIS register 45 stores at least the CIS data necessary to make an initial start-up of the host unit 2-1, of the CIS data of the card-shaped device which conforms to the first specification and is connectable to the host unit 2-1. In this embodiment, at the time of the initial start-up of the host unit 2-1, the CIS register 45 stores only the CIS data including power supply information necessary to make the initial start-up of the host unit 2-1, of the CIS data of the card-shaped device in conformance with the first specification. The power supply information indicates the power supply voltage of the card-shaped device. The CIS data is read from the CIS register 45 in response to a request from the host unit 2-1.

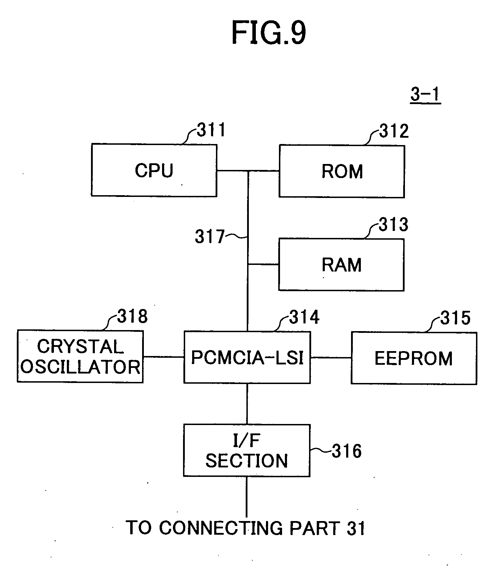

The COR register 46 stores Configuration Option Register (COR) data of the card-shaped device which is connectable to the host unit 2-1. In this embodiment, the COR register 46 stores the COR data of the card-shaped device in conformance with the first specification. Inside the card-shaped device, the COR is formed by a ROM 312 and an EEPROM 315 shown in FIG. 9, for example, as will be described later. The COR data is read from the COR register 46 in response to a read request from the host unit 2-1.

The register section 47 is provided for the CIS data write, and includes a CIS write register CISWRITE, a CIS write control register EWE1 and a CIS write control register EWE2.

In a case where the host unit 2-1 is capable of recognizing the power supply voltage from the COR data, the power supply voltage may be determined by using the COR data as the card identification information, in place of the CIS data.

The EEPROM controller 48 automatically loads the CIS data from the EEPROM 53 to the register section 47, after a power ON reset by the reset IC 51. The oscillation controller 49 controls the oscillation of the crystal oscillator 52. The interrupt controller 50 controls an interrupt request signal IREQ. The voltage converter 54 includes a known voltage conversion circuit for converting the power supply voltage which conforms to the first specification and is obtained from the host unit 2-1 into a power supply voltage which conforms to the second specification, and for supplying the converted power supply voltage to the card-shaped device 3-1. In this embodiment, the voltage converter 54 converts the 3.3 V power supply voltage from the host unit 2-1 into the 5.0 V power supply voltage, and supplies this 5.0 V power supply voltage to the card-shaped device 3-1. In FIG. 7, VCC denotes a power supply input terminal, and GND denotes a ground terminal.

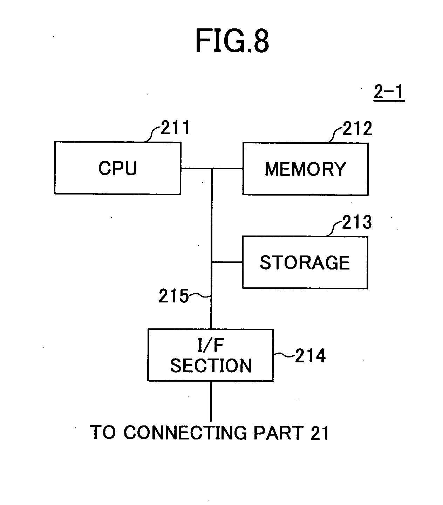

FIG. 8 is a system block diagram showing the structure of the host unit 2-1. The host unit 2-1 shown in FIG. 8 includes a CPU 211, a memory 212, a storage 213 and an interface (I/F) section 214 which are connected via a bus 215. For example, the memory 212 is formed by a RAM or the like, and is used as a work area or the like for the CPU 211. The storage 213 is formed by a disk drive or the like, and stores various data and programs to be executed by the CPU 211. The I/F section 214 provides an interface between the host unit 2-1 and an external unit, and is connected to the connecting part 21 (not shown in FIG. 8).

Of course, the structure of the host unit is not limited to that shown in FIG. 8.

FIG. 9 is a system block diagram showing the structure of the card-shaped device 3-1. The card-shaped device 3-1 shown in FIG. 9 includes a CPU 311, a ROM 312, a RAM 313 and a PCMCIA-LSI 314 which are connected via a bus 317, a crystal oscillator 318, an EEPROM 315, and an interface (I/F) section 316. The EEPROM 315 is connected to the PCMCIA-LSI 314. The ROM 312 and the RAM 313 store various data and programs to be executed by the CPU 311. The I/F section 316 provides an interface between the card-shaped device 3-1 and an external unit, and is connected to the connecting part 31 (not shown in FIG. 9). The PCMCIA-LSI 314 carries out an interface conversion between the CPU 311 and the I/F section 316. The EEPROM 315 stores the CIS data and the like. The crystal oscillator 318 supplies a clock to the CPU 311 and the PCMCIA-LSI 314.

Of course, the structure of the card-shaped device is not limited to that shown in FIG. 9. In addition, the card-shaped device may have a structure having no processor such as the CPU.

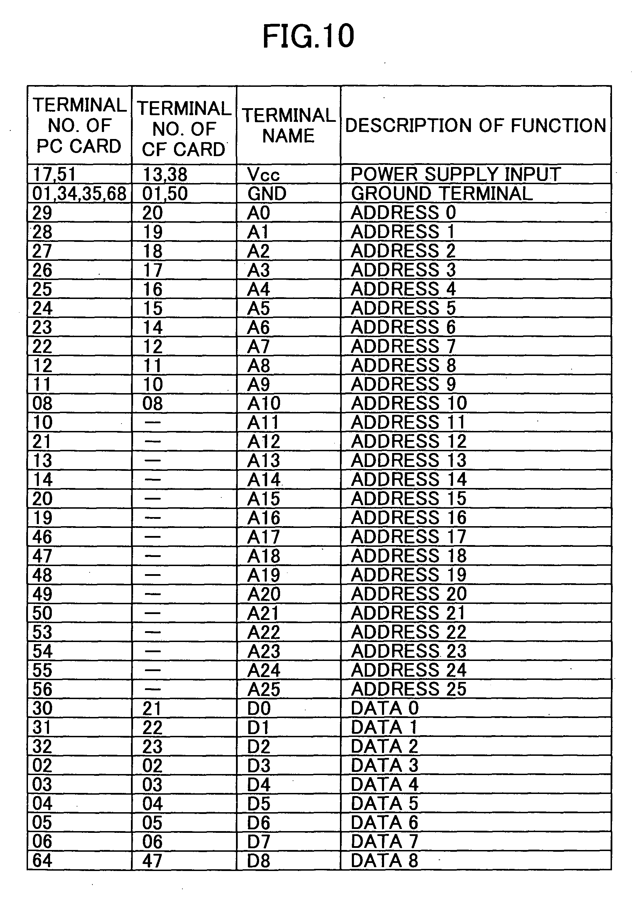

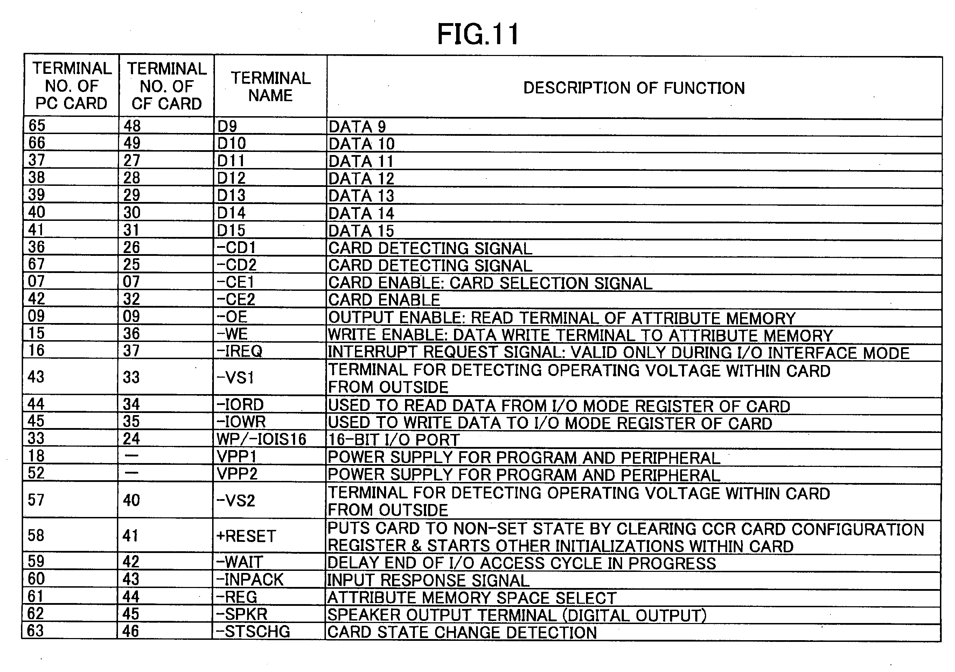

FIGS. 10 and 11 are diagrams for explaining terminal numbers of a PC card, terminal numbers of an FC card, names of terminals shown in FIG. 7, and functions of the terminals. More particularly, FIGS. 10 and 11 are diagrams for explaining the terminal numbers of the card-shaped device (PC card) 3-2, the terminal numbers of the card-shaped device (FC card) 3-1, the names of terminals (signals) shown in FIG. 7, and the functions of the terminals (signals). FIGS. 10 and 11 show a case where the card-device 3-2 is a 68-pin PC card, and the card-shaped device 3-1 is a 50-pin FC card.

As shown in FIGS. 10 and 11, A0 through A25 are address bit terminals, and D0 through D15 are data bit terminals. In FIG. 7, the address bit terminals on the side of the conversion apparatus 1-1 are denoted by reference characters with a prefix "I". In addition, FIG. 7 shows only the address bit terminals A0 through A9 which need to be connected, of the address bit terminals A0 through A10. Moreover, FIG. 7 shows only the data bit terminals D0 through D7 which need to be connected, of the data bit terminals D0 through D15. In FIG. 11, CD1 and CD2 respectively denote card detecting signal terminals, and CE1 and CE2 respectively denote card enable signal (card selection signal) terminals. Further, OE denotes an output enable signal terminal, and WE denotes a write enable signal terminal. The output enable signal terminal OE is used for reading data from a known attribute memory (not shown) within the card-shaped device. The write enable signal terminal WE is used for writing data to the attribute memory within the card-shaped device. The attribute memory within the card-shaped device stores attribute data and the like of the card-shaped device, and is also used as a work area. For example, the RAM 313 shown in FIG. 9 forms the attribute memory. In FIG. 7, the terminals other than the address bit terminals on the sides of the host unit 2-1 and the card-shaped device 3-1 are denoted by reference characters with a prefix "X", and the terminals other than the address bit terminals on the side of the conversion apparatus 1-1 are denoted by reference characters with a prefix "IX".

In FIG. 11, IREQ denotes a terminal which becomes valid only during an input/output (I/O) interface mode of the interrupt request signal, and VS1 denotes a terminal for making the conversion apparatus 1-1 detect an operating voltage within the card-shaped device 3-1. IORD denotes a terminal for reading data from a known I/O mode register (not shown) for storing the I/O mode within the card-shaped device 3-1, and IOWR denotes a terminal for writing data to the I/O mode register within the card-shaped device 3-1. The I/O mode register within the card-shaped device 3-1 stores information indicating that the card-shaped device is to be used as an I/O card, of the modes which include the I/O mode and the memory mode. For example, the I/O mode register may be formed by the RAM 313 shown in FIG. 9.

In FIG. 11, WP/IOIS16 denotes a 16-bit I/O port. VPP1 and VPP2 respectively denote power supply voltages for the program and the peripheral, and VS2 denotes a terminal for making the conversion apparatus 1-1 detect an operating voltage within the card-shaped device 3-1. REST denotes a terminal for putting the card-shaped device 3-1 in a non-set state by clearing a known Card Configuration Register (CCR) which stores the Card Configuration (CC) within the card-shaped device 3-1, and for starting other initializations within the card-shaped device 3-1. For example, the CCR may be formed by the RAM 313 shown in FIG. 9. WAIT denotes a terminal for delaying an end of an I/O access cycle which is in progress, and INPACK denotes a terminal for an input response signal. REG denotes a terminal for an attribute memory space select signal which selects the attribute memory space within the card-shaped device 3-1. SPKR denotes a speaker output terminal (for digital output), and STSCHG denotes a terminal for detecting a change in state of the card-shaped device 3-1.

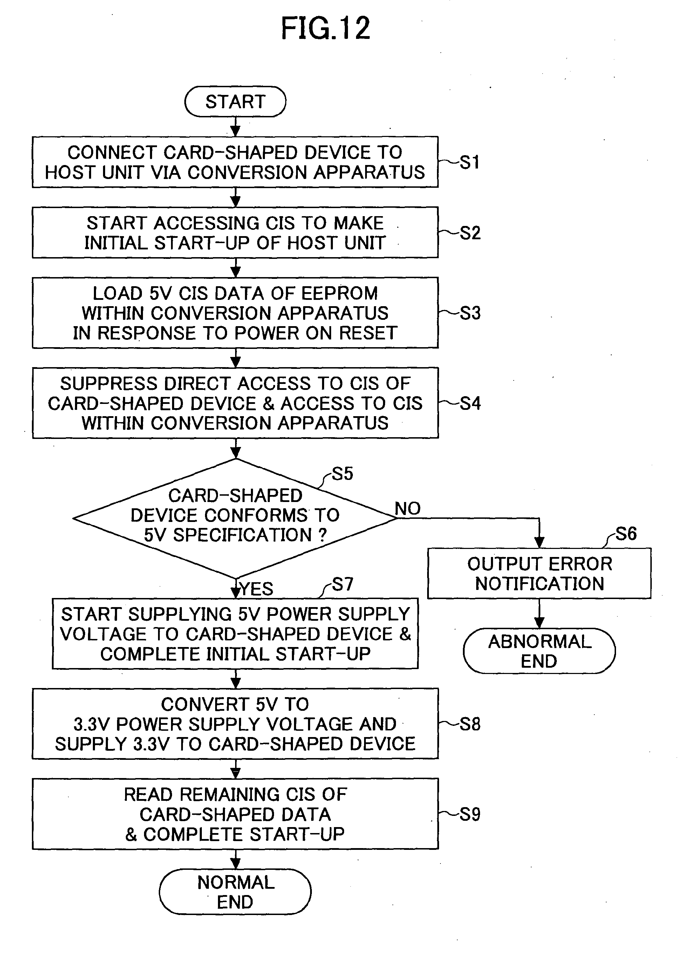

Next, a description will be given of the operation of the conversion apparatus 1-1 shown in FIG. 7, by referring to FIG. 12. FIG. 12 is a flow chart for explaining the operation of the conversion apparatus 1-1.

In a step S1 shown in FIG. 12, an operator (or user) connects the card-shaped device 3-1 to the host unit 2-1 via the conversion apparatus 1-1. In a step S2, the host unit 2-1 makes a CIS data access request to start accessing the CIS data, in order to carry out an initial start-up of the host unit 2-1. In a step S3, the CIS data of the card-shaped device in conformance with the first specification and stored in the EEPROM 53 within the conversion apparatus 1-1 is loaded to the CIS register 45 under the control of the EEPROM controller 48, in response to a power ON reset. In a step S4, the control signal mask controller 44 suppresses the CIS data access request from the host unit 2-1 with respect to the attribute memory within the card-shaped device 3-1, and instead makes access to the CIS register 45 within the conversion apparatus 1-1. As a result, the CIS data within the CIS register 45 is read into the host unit 2-1.

In a step S5, the host unit 2-1 recognizes that the connected card-shaped device conforms to the first specification, from the physical shape of the conversion apparatus 1-1, and provisionally determines the power supply voltage to 5.0 V which conforms to the first specification. In addition, the step S5 decides whether or not the connected card-shaped device 3-1 conforms to the first specification, based on only the power supply information of the read CIS data. If the decision result in the step S5 is NO, the host unit 2-1 judges that an error is generated and makes an error notification to the operator in a step S6. In this case, the process shown in FIG. 12 ends as an abnormal end. The error notification to the operator may be made by a known means including displaying of messages, outputting of alarm sounds and the like.

On the other hand, if the decision result in the step S5 is YES, the host unit 2-1 determines the power supply voltage to be supplied to 5.0 V which conforms to the first specification, and starts supplying the 5.0 V power supply voltage so as to complete the initial start-up, in a step S7. In a step S8, the voltage converter 54 within the conversion apparatus 1-1 converts the 5.0 V power supply voltage from the host unit 2-1 into a 3.3 V power supply voltage which conforms to the second specification, and starts supplying the 3.3 V power supply voltage to the card-shaped device 3-1. In a step S9, the host unit 2-1 reads the remaining CIS data of the card-shaped device 3-1 to complete the start-up, and the process ends as a normal end.

Since the host unit 2-1 reads the CIS data from the conversion apparatus 1-1 and not the card-shaped device 3-1, the host unit 2-1 regards the connected card-shaped device 3-1 as if it were in conformance with the first specification and starts supplying the 5.0 V power supply voltage which conforms to the first specification. However, this 5. 0 V power supply voltage is converted within the conversion apparatus 1-1 into the 3.3 V power supply voltage which conforms to the second specification before being supplied to the card-shaped device 3-1. For this reason, although the connected card-shaped device 3-1 conforms to the second specification which is different from the first specification for which the host unit 2-1 is originally designed, the provision of the conversion apparatus 1-1 between the host unit 2-1 and the card-shaped device 3-1 enables the host unit 2-1 to use the card-shaped device 3-1.

When reading the remaining CIS data of the card-shaped device 3-1 in the step S9, if the remaining CIS data is read directly from the card-shaped device 3-1, the read power supply information will be different from the power supply information read by the host unit 2-1 in the step S4. Hence, in the step S9, the CIS data of the card-shaped device 3-1 is once written into the register section 47 within the conversion apparatus 1-1, and the CIS data other than the power supply information is stored as it is in the CIS register 45, while the power supply information is replaced by the power supply information read from the EEPROM 53 and stored in the CIS register 45. Accordingly, when the host unit 2-1 accesses the remaining CIS data of the card-shaped device 3-1 in the step S9, the CIS data within the CIS register 45 of the conversion apparatus 1-1 is read, and the start-up is completed by accessing the remaining CIS data. When the start-up is completed, the host unit 2-1 may thereafter bypass the conversion apparatus 1-1 and make direct exchanges with the card-shaped device 3-1.

The data to be replaced when storing the CIS data of the card-shaped device 3-1 into the CIS register 45 within the conversion apparatus 1-1 is of course not limited to the power supply information. In addition, it is also possible to replace if necessary, in addition to the power supply information, manufacturer information, product name information, version information and the like included in the CIS data.

In each of the embodiments described above, the power supply information of the CIS data is the power information called CISTPL_DEVICE (The 5 volt Device information Tuples) referred to by the host unit which supplies a 5.0 V power supply voltage or, the power supply information called CISTPL_DEVICE_OC (The Other Conditions Device Information Tuples) referred to by the host unit which supplies a 3.3 V power supply voltage, in the case of a PC card in conformance with the PC Card Standard Release 8.0 (Card Standard Volume 4 Metaformat Specification), for example. Moreover, in the case of such a PC card, the manufacturer information, the product name information, the version information and the like included in the CIS data is the information called CISTPL_VERS_1 (Level 1 Version/Product information tuple). The CIS data includes, in addition to the information described above, other information related to a data format, protocol and the like, but such other information is not directly related to the subject matter of the present invention and a description thereof will be omitted.

Further, the present invention is not limited to these embodiments, but various variations and modifications may be made without departing from the scope of the present invention.

## Claims

1. A conversion apparatus connectable to an information processing apparatus which is designed for a device in conformance with a first specification, **characterized by**:
a connecting part having a physical shape which enables a device in conformance with a second specification to be connected to the information processing apparatus, said second specification being different from said first specification;
a storage to store identification information of the device in conformance with the first specification, said identification information being read from said storage in place of identification information stored within the device in conformance with the second specification and connected to the information processing apparatus, when the information processing apparatus makes access to the identification information of the device in conformance with the second specification; and
a voltage converter to convert a power supply voltage from the information processing apparatus into a converted power supply voltage in accordance with the second specification and to supply the converted power supply voltage to the device in conformance with the second specification.

2. The conversion apparatus as claimed in claim 1, **characterized in that** the devices are portable card media.

3. The conversion apparatus as claimed in claim 1 or 2, **characterized in that** a power supply voltage in accordance with the first specification is 3.3 V, and a power supply voltage in accordance with the second specification is 5.0 V.

4. The conversion apparatus as claimed in claim 1 or 2, **characterized in that** a power supply voltage in accordance with the first specification is 5.0 V, and a power supply voltage in accordance with the second specification is 3.3 V.

5. The conversion apparatus as claimed in claim 1, **characterized in that** said storage stores at least identification information necessary to make an initial start-up within the information processing apparatus when using the device.

6. The conversion apparatus as claimed in claim 5, **characterized in that** the identification information necessary to make the initial start-up includes power supply information.

7. The conversion apparatus as claimed in claim 1 or 2, **characterized in that** the device in conformance with the first specification and the device in conformance with the second specification are same kind of devices.

8. The conversion apparatus as claimed in claim 1 or 2, **characterized in that** the device in conformance with the first specification and the device in conformance with the second specification are different kinds of devices.
